# FASCICULE DE BREVET EUROPEEN

(11) **EP 3 236 496 B1**
(45) Date de publication et mention de la délivrance du brevet: **30.12.2020**
(21) Numéro de dépôt: 16198719.3
(22) Date de dépôt: 14.11.2016
(51) Int. Cl.: H01L 23/58

(54) **PUCE ÉLECTRONIQUE PROTÉGÉE CONTRE DES ATTAQUES EN FACE ARRIÈRE**
ELEKTRONISCHER CHIP MIT SCHUTZ GEGEN ANGRIFFE VON DER RÜCKSEITE
ELECTRONIC CHIP WITH BACKSIDE ATTACK PROTECTION

(30) Priorité: 19.04.2016 FR 1653456
(43) Date de publication de la demande: 25.10.2017
(73) Titulaire: STMICROELECTRONICS (ROUSSET) SAS, 13790 Rousset (FR)
(72) Inventeur: SARAFIANOS, Alexandre, 13530 Trets (FR); LISART, Mathieu, 13100 Aix-en-Provence (FR); FORT, Jimmy, 13114 Puyloubier (FR)
(74) Mandataire: Cabinet Beaumont

(56) Documents cités:
- FR-A1- 2 986 356
- FR-A1- 2 998 419

## Description

### Domaine

La présente demande concerne les puces électroniques, plus particulièrement une puce électronique protégée contre des attaques effectuées depuis la face arrière de la puce.

### Exposé de l'art antérieur

Des puces électroniques contenant des informations confidentielles, telles que des puces de cartes bancaires, sont susceptibles de subir des attaques de pirates visant à déterminer le fonctionnement de la puce et à en extraire les informations confidentielles. Les documents FR2986356 et FR2998419 décrivent des puces électroniques protégées contre de telles attaques.

La demande de brevet français N° 15/59292 déposée le 30 septembre 2015 par la demanderesse et publiée le 31.03.2017 avec comme numéro de publication FR 3 041 814 A1 décrit des puces électroniques protégées contre des attaques de pirates. Les figures 1A et 1B illustrent les éléments décrits en relation avec les figures 3A et 3B de cette demande de brevet.

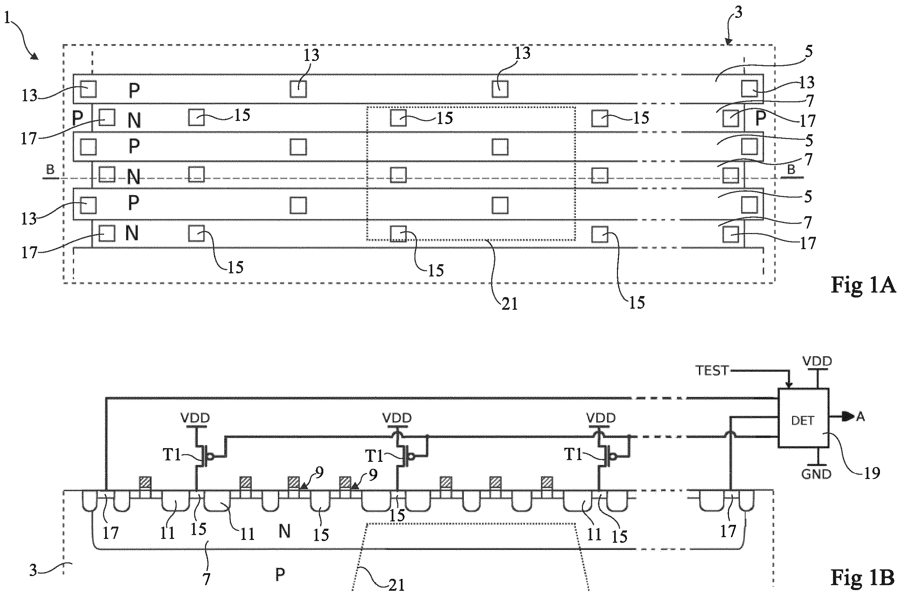

La figure 1A est une vue de dessus partielle et schématique d'une puce électronique 1. La figure 1B est une vue en coupe selon le plan B-B de la figure 1A et illustre en outre un circuit de détection d'attaque.

La puce 1 comprend, en partie supérieure d'une tranche semiconductrice 3 dopée de type P, par exemple en silicium, des caissons 5 dopés de type P et des caissons 7 dopés de type N alternés à un pas inférieur à 5 µm. Chacun des caissons 5 et 7 est en forme de barre. Les caissons P 5 peuvent être des régions plus fortement dopées que la tranche semiconductrice 3 ou peuvent être des portions de la tranche semiconductrice 3 délimitées par les caissons N 7.

Des composants élémentaires de circuits, c'est-à-dire des éléments tels que des transistors, des résistances, des capacités ou des composants comportant des jonctions P-N, sont formés dans et sur les caissons P 5 et dans et sur les caissons N 7. A titre d'exemple, des transistors MOS 9 sont représentés schématiquement dans la vue en coupe de la figure 1B. Les composants élémentaires sont formés dans des zones actives entourées de tranchées d'isolement 11.

Chaque caisson P 5 est muni de contacts de polarisation 13 reliés à une masse GND. Chaque caisson N 7 est muni de contacts de polarisation 15 reliés par l'intermédiaire de transistors T1 à une source de potentiel haut VDD.

Chaque caisson N 7 comprend sur sa face supérieure un contact de détection 17 à chacune de ses extrémités. Les contacts de détection 17 de chaque caisson N 7 sont reliés à un circuit de détection 19. Chaque circuit de détection 19 est alimenté entre le potentiel VDD et la masse GND. Chaque circuit de détection 19 reçoit un signal de test TEST et est adapté à fournir un signal d'alerte A.

Au cours d'une phase de test qui peut avoir lieu lors du démarrage de la puce, les signaux de test sont activés successivement par la puce. Le circuit de détection qui reçoit un signal de test bloque les transistors T1 associés et compare à une valeur de seuil la résistance électrique du caisson entre les contacts de détection 17. En l'absence d'attaque, chaque caisson a une résistance inférieure à la valeur de seuil, et aucun signal d'alerte n'est émis.

On considère ici le cas où, pour réaliser une attaque, un pirate creuse une cavité 21 à partir de la face inférieure de la puce, par exemple par un faisceau d'ions. La cavité 21 a des dimensions latérales supérieures à 5 µm. Le pirate compte installer dans cette cavité des contacts avec les composants situés en face supérieure, et analyser le fonctionnement de la puce.

La présence de la cavité affecte un caisson N 7, dont la résistance augmente. Cette augmentation de résistance est détectée par le circuit de détection 19 correspondant et un signal d'alerte A est émis. A ce signal, la puce détruit ou cache les données confidentielles, ou encore stoppe son fonctionnement, et le pirate n'a pas la possibilité de poursuivre son attaque.

De tels dispositifs de détection utilisant des mesures de résistances de caissons fonctionnent de manière satisfaisante, mais on peut souhaiter améliorer le seuil de détection et simplifier le circuit de détection.

### Résumé

Ainsi, l'invention prévoit une puce électronique selon la revendication 1 comprenant : une pluralité de premières barres semiconductrices d'un premier type de conductivité et de deuxièmes barres semiconductrices d'un deuxième type de conductivité disposées de manière alternée et contiguë sur une région du premier type de conductivité ; deux contacts de détection disposés aux extrémités de chaque deuxième barre ; un circuit de détection de la résistance entre les contacts de détection de chaque deuxième barre ; des tranchées d'isolement s'étendant dans les deuxièmes barres sur une première profondeur entre des éléments de circuit ; et des murs d'isolement s'étendant sur toute la largeur de chaque deuxième barre sur une deuxième profondeur supérieure à la première profondeur, des éléments de circuit étant disposés entre deux murs d'isolement voisins d'une même des deuxièmes barres, lesdits deux murs d'isolement voisins étant distants de moins de 5 µm.

Selon un mode de réalisation, le rapport entre la deuxième profondeur et la première profondeur est supérieur à 1,5.

Selon un mode de réalisation, la puce comprend sur chacune des deuxièmes barres une pluralité de contacts de polarisation dont chacun est relié par un interrupteur à une source de potentiel de polarisation.

Selon un mode de réalisation, chaque mur d'isolement a une partie située dans une tranchée d'isolement.

Selon un mode de réalisation, une région dopée du premier type de conductivité est située en partie inférieure de chaque mur d'isolement.

Selon un mode de réalisation, les murs d'isolement ont une largeur comprise entre 50 et 150 nm.

Selon un mode de réalisation, chaque circuit de détection est adapté à comparer la résistance électrique de deux des deuxièmes barres et à produire un signal d'alerte lorsque le rapport entre les résistances électriques des deux deuxièmes barres devient supérieur à un seuil.

Selon un mode de réalisation, ledit seuil est compris entre 2 et 5.

Selon un mode de réalisation, chaque circuit de détection est adapté à appliquer une tension sur les contacts de détection desdites deux deuxièmes barres et à comparer une valeur amplifiée d'un courant circulant dans l'une des deux deuxièmes barres à une valeur d'un courant circulant dans l'autre des deux deuxièmes barres.

Selon un mode de réalisation, ladite tension est comprise entre 300 et 600 mV.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue de dessus partielle et schématique d'une puce électronique selon la demande FR 3 041 814 A1 ;
la figure 1B est une vue en coupe d'une puce électronique et illustre un circuit de détection d'attaques selon la demande FR 3 041 814 A1 ;
la figure 2A est une vue de dessus partielle et schématique d'un mode de réalisation d'une puce électronique selon l'invention ;
la figure 2B est une vue en coupe du mode de réalisation représenté en figure 2A et illustre un circuit de détection ;
la figure 3 est une vue en coupe, partielle et schématique, illustrant un exemple d'un mur d'isolement ;
la figure 4 est une vue en coupe, partielle et schématique, illustrant un autre exemple d'un mur d'isolement ;
la figure 5 est une vue en coupe, partielle et schématique, illustrant un autre exemple d'un mur d'isolement ; et
la figure 6 représente un exemple de circuit de détection connecté à deux caissons.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, des composants élémentaires de circuits ne sont pas représentés en vue de dessus.

Dans la description qui suit, lorsque l'on fait référence à des qualificatifs de position, tels que les termes "dessus", "dessous", "supérieur", "inférieur", etc., ou à des qualificatifs d'orientation, tels que le terme "vertical", etc., il est fait référence à l'orientation de l'élément concerné dans les vues en coupe.

Dans la présente description, le terme "connecté" désigne une connexion électrique directe entre deux éléments, tandis que le terme "couplé" désigne une connexion électrique entre deux éléments qui peut être directe ou par l'intermédiaire d'un ou de plusieurs composants passifs ou actifs, comme des résistances, des condensateurs, des inductances, des diodes, des transistors, etc.

L'attaque par un pirate d'une puce du type de la puce 1 des figures 1A et 1B a été analysée. Quand le pirate grave une cavité d'attaque, la résistance du caisson endommagé ne franchit le seuil de résistance que lorsque la cavité se rapproche des tranchées d'isolement, voire quand elle atteint ces tranchées. Or, les caissons N 7 de la puce 1 peuvent avoir une profondeur comprise entre 1 et 2 µm et les tranchées d'isolement 11 s'étendent à partir de la face supérieure sur une profondeur par exemple inférieure à 0,5 µm. Un pirate pourrait, par essais successifs, graver une cavité qui s'étend à travers une part importante de la profondeur du caisson et qui s'arrête à une distance suffisante du fond des tranchées pour que l'attaque ne soit pas détectée. Il existe alors un risque que le pirate puisse tout de même obtenir par cette cavité les informations qu'il convoite. Le circuit de détection doit être prévu pour éviter ce risque, en particulier par un réglage précis de la résistance de seuil, ce qui pose des problèmes pratiques de réalisation.

On souhaite donc obtenir une puce électronique ayant un niveau de protection supérieur à celui de la puce des figures 1A et 1B.

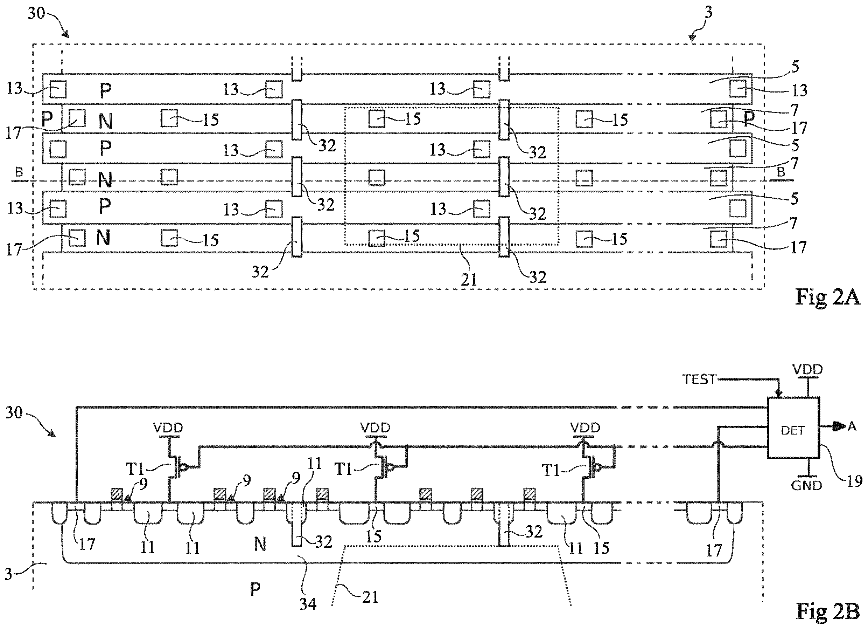

La figure 2A est une vue de dessus partielle et schématique d'un mode de réalisation d'une puce électronique 30 protégée contre des attaques. La figure 2B est une vue en coupe selon le plan B-B de la figure 2A et illustre en outre un circuit de détection d'attaque.

La puce 30 reprend les éléments de la puce 1 illustrée en figures 1A et 1B, à savoir :
- une alternance de caissons 5 dopés de type P et de caissons 7 dopés de type N en forme de barres, disposés en partie supérieure d'une tranche semiconductrice 3 ;
- des tranchées d'isolement 11 séparant des éléments de circuit tels que des transistors 9 ;
- des contacts de polarisation 13 et 15 situés sur les caissons respectifs 5 et 7, les contacts 15 étant connectés par des transistors T1 à une source de potentiel VDD ;
- des contacts de détection 17 aux extrémités des caissons N 7 ; et
- pour chaque caisson N 7, un circuit de détection 19 adapté à générer un signal d'alerte A lorsque la résistance du caisson entre les contacts de détection 17 devient supérieure à une résistance de seuil.

La puce 30 comprend en outre des murs d'isolement 32 qui s'étendent transversalement dans les caissons N 7 à partir de la face supérieure du caisson sur une profondeur supérieure à la profondeur des tranchées. A titre d'exemple, la profondeur des murs d'isolement est supérieure à 1,5 fois la profondeur des tranchées. La profondeur des murs d'isolement peut être de l'ordre de 0,6 µm, par exemple comprise entre 0,5 et 0,7 µm. Des portions 34 des caissons N 7 sont situées en dessous des murs d'isolement. Chacun des murs d'isolement 32 s'étend dans une direction orthogonale à la direction des barres sur l'intégralité de la largeur des barres.

Le fonctionnement de la puce 30 est similaire à celui de la puce 1 décrite en relation avec les figures 1A et 1B. En effet, les portions 34 d'un caisson N 7 assurent la continuité électrique du caisson entre les contacts de détection 17. En l'absence d'attaque par creusement de la face arrière, tous les caissons N 7 ont une même valeur de résistance, dite valeur normale.

Au cours du creusement d'une cavité 21 par un pirate, dès que la cavité atteint une portion 34 d'un caisson N 7 située sous un mur d'isolement 32, la résistance électrique du caisson N 7 augmente. Cette résistance devient infinie dès que la cavité 21 atteint le fond du mur d'isolement 32.

Pour que son attaque ne soit pas détectée, le pirate devrait arrêter de graver la cavité avant d'atteindre le fond des murs d'isolement, c'est-à-dire loin du fond des tranchées. Une partie importante du caisson N subsiste alors entre les composants élémentaires et la cavité. De ce fait, le pirate n'a plus la possibilité d'identifier les contributions des divers composants individuels disposés en regard de la cavité.

Ainsi, la présence des murs d'isolement plus profonds que les tranchées permet de contrer l'attaque d'une manière particulièrement précoce, assurant un niveau de protection particulièrement élevé contre les attaques de pirates.

Ce niveau de protection particulièrement élevé est assuré pour les éléments de circuit disposés entre deux murs d'isolement voisins d'un même caisson N 7 lorsque la distance entre les murs voisins est inférieure à la dimension latérale de la cavité 21. Selon l'invention, les murs d'isolement voisins sont séparés d'une distance inférieure à 5 µm. A titre d'exemple, les murs d'isolement 32 peuvent être répartis le long de chaque caisson N 7 ou peuvent être présents seulement dans des portions de caissons comprenant des éléments de circuit que l'on souhaite protéger particulièrement.

A titre d'exemple, les murs d'isolement peuvent s'étendre sur une longueur supérieure à la largeur des barres, et peuvent s'étendre au travers de plusieurs caissons P 5 et N 7.

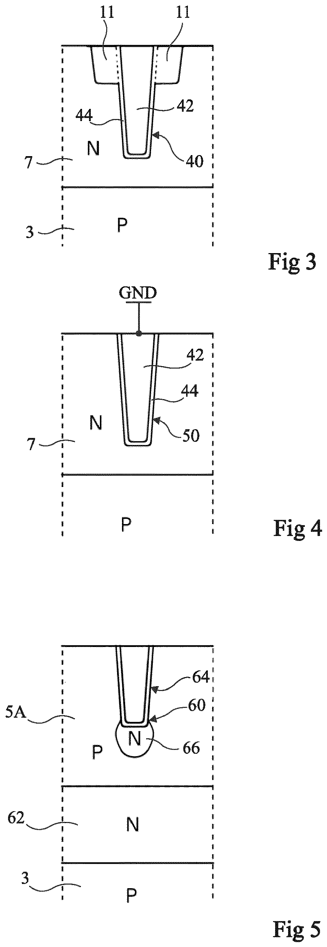

La figure 3 est une vue en coupe, partielle et schématique, à une échelle différente de celle des figures 2A et 2B, et illustre un exemple de mur d'isolement 40 dans un caisson N 7. Le mur d'isolement 40 s'étend à travers une tranchée d'isolement 11. Le mur d'isolement 40 comprend un mur conducteur 42 par exemple en silicium polycristallin isolé du caisson N 7 par des parois isolantes 44 par exemple en oxyde de silicium.

Du fait de la position du mur d'isolement dans une tranchée d'isolement 11, le mur d'isolement n'occupe pas de place utilisable pour les circuits. De ce fait, un niveau de protection particulièrement élevé contre des attaques de pirates peut être obtenu sans augmenter la surface de la puce.

De plus, la prévision des murs d'isolement 40 n'ajoute généralement pas d'étapes de fabrication, des structures similaires à de tels murs d'isolement étant souvent prévues à d'autres fins dans une puce électronique.

A titre d'exemple, la largeur des murs est comprise entre 50 et 150 nm. A titre d'exemple, l'épaisseur de la paroi d'oxyde de silicium des murs d'isolement 40 est comprise entre 5 nm et 20 nm.

La figure 4 est une vue en coupe, partielle et schématique, illustrant un autre exemple de mur d'isolement 50 situé dans un caisson N 7. Le mur d'isolement 50 comprend un mur conducteur 42 isolé du caisson N 7 par une paroi 44. Le mur conducteur est par exemple connecté à la masse GND.

Le mur d'isolement 50 constitue alors un élément capacitif entre la masse et le caisson N 7. En plus de la protection contre les attaques, la présence de cet élément capacitif améliore le fonctionnement de la puce en stabilisant le potentiel du caisson N 7.

La figure 5 est une vue en coupe, partielle et schématique, illustrant un exemple d'un autre mode de réalisation d'un mur d'isolement 60.

La structure de la figure 5 est obtenue par un procédé comprenant une étape de dopage de type N d'une partie supérieure d'une tranche semiconductrice 3 pour former une région 62, suivie d'une étape de formation d'une structure 64 similaire à celle du mur d'isolement 50 de la figure 4, suivie d'une étape de formation de caissons 5A dopés de type P en forme de barres. Les caissons P 5A sont équipés à leurs extrémités de contacts de détection (non visibles) et leurs résistances sont mesurées par des circuits de détection d'attaque.

Le mur d'isolement 60 obtenu comprend une zone 66 dopée de type N située au-dessous de la structure 64 et en contact avec celle-ci. La zone dopée 66 s'étend sur la largeur du caisson 5A et est en contact avec deux caissons dopés de type N (non visibles dans le plan de coupe) disposés de part et d'autre du caisson P 5A.

En fonctionnement, la zone 66 est portée au niveau haut de potentiel appliqué aux caissons N. Aucun courant ne peut circuler à travers la zone 66 entre les parties du caisson P 5A situées de part et d'autre de la zone 66.

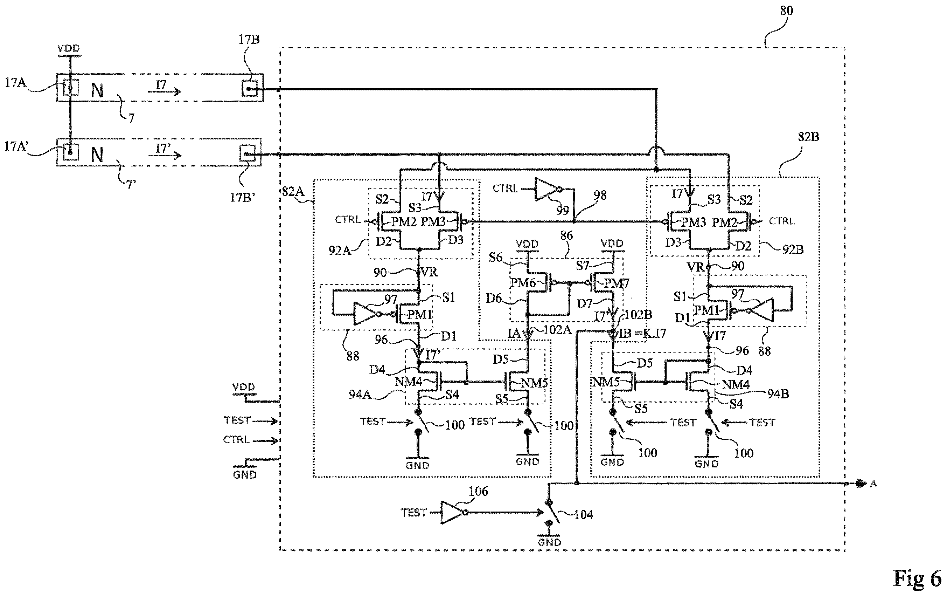

La figure 6 représente, uniquement à titre d'exemple, un mode de réalisation d'un circuit de détection 80 connecté à deux caissons 7 et 7' similaires dopés de type N. Chaque caisson 7, 7' est représenté en vue de dessus de manière simplifiée. Le caisson 7 est muni de contacts de détection 17A et 17B et le caisson 7' est muni de contacts de détection 17A' et 17B'. Les contacts 17A et 17A' sont connectés ensemble à la source de potentiel VDD. Le circuit de détection 80, alimenté entre les potentiels VDD et la masse GND, peut recevoir un signal de test TEST et un signal de commande CTRL, et peut générer un signal d'alerte A.

Le circuit de détection 80 comprend deux circuits de mesure de résistance 82A et 82B destinés chacun à appliquer une différence de potentiel régulée VDD-VR entre les contacts de détection des barres 7 et 7' et à fournir des courants IA et IB images des courants circulant alors dans les barres. Un miroir de courant 86 est prévu afin de comparer les courants IA et IB pour fournir le signal d'alerte.

Chaque circuit de mesure 82A et 82B comprend :
- un régulateur de tension 88 destiné à réguler le potentiel VR d'un noeud 90 ;
- un commutateur 92A, 92B destiné à appliquer le potentiel du noeud 90 en fonction du signal de commande CTRL reçu par le circuit de détection 80 ; et
- un miroir de courant 94A, 94B adapté à fournir le courant IA, IB à partir du courant qui provient d'une barre et qui passe par le régulateur de tension 88.

Chaque régulateur de tension 88 comprend un transistor PM1 de type MOS à canal P dont la source S1 est couplée au noeud 90 et le drain D1 est couplé à un noeud 96. La grille du transistor PM1 est couplée à la sortie d'un inverseur 97 dont l'entrée est couplée au noeud 90. Le potentiel régulé VR est égal au potentiel de seuil de l'inverseur 97.

Chaque commutateur 92A, 92B comprend deux transistors PM2 et PM3 de type MOS à canal P dont les drains D2 et D3 sont connectés au noeud 90. Le transistor PM2 est commandé par le signal CTRL. La grille du transistor PM3 est couplée à un noeud de sortie 98 d'un inverseur 99 recevant le signal CTRL.

La source S2 du transistor PM2 du circuit 92A et la source S3 du transistor PM3 du circuit 92B sont connectées au contact de détection 17B. La source S2 du circuit 92B et la source S3 du circuit 92A sont connectées au contact de détection 17B'.

Chaque miroir de courant 94A, 94B comprend des transistors NM4 et NM5 de type MOS à canal N dont les grilles sont couplées au noeud 96. Les sources S4 et S5 des transistors NM4 et NM5 sont couplées à la masse GND par des interrupteurs 100. Le transistor NM4 a son drain D4 couplé au noeud 96. Le drain D5 du transistor NM5 est connecté à un noeud 102A, 102B de sortie du circuit de mesure 82A, 82B.

Le miroir de courant 86 a une branche d'entrée connectée à la sortie 102A du circuit 82A et une branche de sortie connectée à la sortie 102B du circuit 82B. Le miroir de courant 96 comprend des transistors PM6 et PM7 de type MOS à canal P dont les grilles sont couplées au noeud 102A et les sources S6 et S7 sont couplées à la source de potentiel VDD. Le drain D6 du transistor PM6 est couplé au noeud 102A et le drain D7 du transistor PM7 est couplé au noeud 102B.

Le noeud 102B est par ailleurs couplé à la masse par un interrupteur 104 commandé par la sortie d'un inverseur 106 recevant le signal TEST. Le signal d'alerte A correspond au niveau de potentiel du noeud 102B.

Lors de la phase de test, pendant que le signal de test TEST est activé, le signal de commande CTRL est porté successivement à un niveau haut puis à un niveau bas.

Quand le signal de commande CTRL est au niveau haut, le circuit de mesure 82A applique le potentiel VR sur le contact de détection 17B'. Un courant I7' circule dans la barre 7' et dans la branche d'entrée du miroir 94A. Les miroirs de courant 94A et 86 connectés en série sont prévus pour injecter alors dans le noeud 102B un courant d'intensité égale à celle du courant I7'. Par ailleurs, le circuit de mesure 82B applique le potentiel VR sur le contact de détection 17B. Un courant I7 circule dans la barre 7 et dans la branche d'entrée du miroir 94B. Le miroir de courant 94B est prévu pour amplifier le courant I7 d'un facteur K, et absorber ce courant amplifié K*I7 à partir du noeud 102B.

En cas d'attaque, lorsque le rapport entre la résistance du caisson 7 et celle du caisson 7' est supérieur au facteur d'amplification K, le courant I7' injecté dans le noeud 102B est d'intensité supérieure à celle du courant K*I7 absorbé à partir du noeud 102B. Le potentiel du noeud 102B augmente et sature à un niveau haut. Ainsi, le signal d'alerte A est émis.

En l'absence d'attaque, les résistances sont égales et les courants I7 et I7' sont égaux. Le potentiel du noeud 102B diminue et sature à un niveau bas.

Lorsque le signal TEST est actif et le signal CTRL est au niveau bas, le fonctionnement est similaire à celui décrit ci-dessus, les rôles des contacts de détection 17B et 17B' des caissons 7 et 7' ayant été inversés par les commutateurs. Le signal d'alerte A est émis lorsque le rapport entre la résistance du caisson 7' et celle du caisson 7 est supérieur au facteur d'amplification K.

Le circuit de détection permet donc de détecter successivement pendant la phase de test une attaque sur l'un ou l'autre des caissons 7 et 7'.

En l'absence de signal de test TEST, l'interrupteur 104 est passant et aucun signal d'alerte n'est émis.

A titre d'exemple, le facteur d'amplification K est compris entre 2 et 5. A titre d'exemple, la tension de seuil VR des inverseurs 97 est comprise entre 300 mV et 600 mV.

Des modes de réalisation particuliers ont été décrits. Diverses variantes et modifications incluses dans l'étendue des revendications apparaîtront à l'homme de l'art. En particulier, bien que les contacts de polarisation 15 soient couplés à la source de potentiel VDD par des transistors de type MOS, les contacts de polarisation 15 peuvent être couplés à la source de potentiel VDD par des interrupteurs de tout autre type adapté, par exemple des transistors bipolaires.

De plus, d'autres modes de réalisation possibles correspondent aux modes de réalisation décrits ci-dessus dans lesquels les types de conductivité N et P sont échangés, les types de canal des transistors MOS étant alors échangés, et les valeurs basse GND et haute VDD de potentiels étant échangées.

Bien qu'un mode de réalisation particulier d'un circuit de détection ait été décrit, tout circuit de détection d'une résistance de caisson peut être utilisé, en particulier tout circuit de détection de type évoqué dans la demande de brevet FR 3 041 814 A1 citée précédemment.

## Revendications

1. Puce électronique comprenant :
une pluralité de premières barres semiconductrices (5) d'un premier type de conductivité et de deuxièmes barres semiconductrices (7) d'un deuxième type de conductivité disposées de manière alternée et contiguë sur une région (3) du premier type de conductivité ;
deux contacts de détection (17) disposés aux extrémités de chaque deuxième barre ;
un circuit de détection (19) de la résistance entre les contacts de détection de chaque deuxième barre ;
des tranchées d'isolement (11) s'étendant dans les deuxièmes barres sur une première profondeur entre des éléments de circuit ; et
des murs d'isolement (32 ; 40 ; 50 ; 60) s'étendant sur toute la largeur de chaque deuxième barre sur une deuxième profondeur supérieure à la première profondeur,
des éléments de circuit étant disposés entre deux murs d'isolement voisins d'une même des deuxièmes barres, lesdits deux murs d'isolement voisins étant distants de moins de 5 µm.

2. Puce électronique selon la revendication 1, dans laquelle le rapport entre la deuxième profondeur et la première profondeur est supérieur à 1,5.

3. Puce électronique selon la revendication 1 ou 2, comprenant sur chacune des deuxièmes barres (7) une pluralité de contacts de polarisation (15) dont chacun est relié par un interrupteur (T1) à une source de potentiel de polarisation (VDD).

4. Puce électronique selon l'une quelconque des revendications 1 à 3, dans laquelle chaque mur d'isolement (32 ; 40) a une partie située dans une tranchée d'isolement (11).

5. Puce électronique selon l'une quelconque des revendications 1 à 4, dans laquelle une région (66) dopée du premier type de conductivité est située en partie inférieure de chaque mur d'isolement (60).

6. Puce électronique selon l'une quelconque des revendications 1 à 5, dans laquelle les murs d'isolement (32 ; 40 ; 50 ; 60) ont une largeur comprise entre 50 et 150 nm.

7. Puce électronique selon l'une quelconque des revendications 1 à 6, dans laquelle chaque circuit de détection (80) est adapté à comparer la résistance électrique de deux des deuxièmes barres (7, 7') et à produire un signal d'alerte (A) lorsque le rapport entre les résistances électriques des deux deuxièmes barres devient supérieur à un seuil.

8. Puce électronique selon la revendication 7, dans laquelle ledit seuil est compris entre 2 et 5.

9. Puce électronique selon la revendication 7 ou 8, dans laquelle chaque circuit de détection (80) est adapté à appliquer une tension sur les contacts de détection (17A, 17A', 17B, 17B') desdites deux deuxièmes barres (7, 7') et à comparer une valeur amplifiée (K*I7) d'un courant circulant dans l'une des deux deuxièmes barres à une valeur d'un courant (I7') circulant dans l'autre des deux deuxièmes barres.

10. Puce électronique selon la revendication 9, dans laquelle ladite tension est comprise entre 300 et 600 mV.

## Patentansprüche

1. Ein elektronischer Chip, der Folgendes aufweist:
eine Vielzahl von ersten Halbleiterstäben (5) eines ersten Leitfähigkeitstyps und von zweiten Halbleiterstäben (7) eines zweiten Leitfähigkeitstyps, die abwechselnd und an einander angrenzend auf einem Halbleiterbereich (3) des ersten Leitfähigkeitstyps angeordnet sind;
zwei Detektionskontakte (17), die an den Enden jedes zweiten Stabes angeordnet sind;
eine Detektionsschaltung (19) zum Erfassen des Widerstands zwischen den Detektionskontakten jedes zweiten Stabes;
isolierende Gräben (11), die sich in den zweiten Stäben bis zu einer ersten Tiefe zwischen Schaltungselementen erstrecken; und
isolierende Wände (32; 40; 50; 60), die sich über die gesamte Breite jedes zweiten Stabes bis zu einer zweiten Tiefe erstrecken, die größer ist als die erste Tiefe,
Schaltungselemente, die zwischen zwei benachbarten isolierenden Wänden desselben der zweiten Stäbe angeordnet sind, wobei die beiden benachbarten isolierenden Wände einen Abstand von weniger als 5 µm haben.

2. Elektronischer Chip nach Anspruch 1, wobei das Verhältnis der zweiten Tiefe zur ersten Tiefe größer als 1,5 ist.

3. Elektronischer Chip nach Anspruch 1 oder 2, der auf jedem der zweiten Stäbe (7) eine Vielzahl von Polarisationskontakten (15), von denen jeder durch einen Schalter (T1) mit einer Polarisationspotentialquelle (VDD) verbunden ist, aufweist.

4. Elektronischer Chip nach einem der Ansprüche 1 bis 3, wobei jede isolierende Wand (32; 40) einen Abschnitt aufweist, der sich in einem isolierenden Graben (11) befindet.

5. Elektronischer Chip nach einem der Ansprüche 1 bis 4, wobei ein dotierter Bereich (66) des ersten Leitfähigkeitstyps im unteren Teil jeder isolierenden Wand (60) angeordnet ist.

6. Elektronischer Chip nach einem der Ansprüche 1 bis 5, wobei die isolierenden Wände (32; 40; 50; 60) eine Breite im Bereich von 50 bis 150 nm haben.

7. Elektronischer Chip nach einem der Ansprüche 1 bis 6, wobei jede Detektionsschaltung (80) in der Lage ist, den elektrischen Widerstand von zwei der zweiten Stäbe (7, 7') zu vergleichen und ein Alarmsignal (A) zu erzeugen, wenn das Verhältnis der elektrischen Widerstände der beiden zweiten Stäbe größer als ein Schwellenwert wird.

8. Elektronischer Chip nach Anspruch 7, wobei der Schwellenwert im Bereich von 2 bis 5 liegt.

9. Elektronischer Chip nach Anspruch 7 oder 8, wobei jede Detektionsschaltung (80) in der Lage ist, eine Spannung an die Detektionskontakte (17A, 17A', 17B, 17B') der beiden zweiten Stäbe (7, 7') anzulegen und einen verstärkten Wert (K*I7) eines durch einen der beiden zweiten Stäbe fließenden Stroms mit einem Wert eines durch den anderen der beiden zweiten Stäbe fließenden Stroms (I7') zu vergleichen.

10. Elektronischer Chip nach Anspruch 9, wobei die Spannung im Bereich von 300 bis 600 mV liegt.

## Claims

1. An electronic chip comprising:
a plurality of first semiconductor bars (5) of a first conductivity type and of second semiconductor bars (7) of a second conductivity type alternately and contiguously arranged on a semiconductor region (3) of the first conductivity type;
two detection contacts (17) arranged at the ends of each second bar;
a detection circuit for detecting (19) the resistance between the detection contacts of each second bar;
insulating trenches (11) extending in the second bars down to a first depth between circuit elements; and
insulating walls (32; 40; 50; 60) extending across the entire width of each second bar down to a second depth greater than the first depth,
circuit elements being located between two neighboring insulating walls of a same of said second bars, said two neighboring insulating walls being spaced by less than 5 µm.

2. The electronic chip of claim 1, wherein the ratio of the second depth to the first depth is greater than 1.5.

3. The electronic chip of claim 1 or 2, comprising on each of the second bars (7) a plurality of bias contacts (15), each of which is connected by a switch (T1) to a bias potential source (VDD).

4. The electronic chip of any of claims 1 to 3, wherein each insulating wall (32; 40) has a portion located in an insulating trench (11).

5. The electronic chip of any of claims 1 to 4, wherein a doped region (66) of the first conductivity type is located in the lower portion of each insulating wall (60).

6. The electronic chip of any of claims 1 to 5, wherein the insulating walls (32; 40; 50; 60) have a width in the range from 50 to 150 nm.

7. The electronic chip of any of claims 1 to 6, wherein each detection circuit (80) is capable of comparing the electric resistance of two of the second bars (7, 7') and of generating an alert signal (A) when the ratio of the electric resistances of the two second bars becomes greater than a threshold.

8. The electronic chip of claim 7, wherein said threshold is in the range from 2 to 5.

9. The electronic chip of claim 7 or 8, wherein each detection circuit (80) is capable of applying a voltage on the detection contacts (17A, 17A', 17B, 17B') of said two second bars (7, 7') and of comparing an amplified value (K*I7) of a current flowing through one of the two second bars with a value of a current (I7') flowing through the other one of the two second bars.

10. The electronic chip of claim 9, wherein said voltage is in the range from 300 to 600 mV.
